# EUROPEAN PATENT APPLICATION

(11) **EP 4 195 353 A1**
(43) Date of publication of application: **14.06.2023**
(21) Application number: 21214142.8
(22) Date of filing: 13.12.2021
(51) Int. Cl.: H01M 10/42, H01M 50/209, H01M 50/249, H01M 50/507, H01M 50/51, H01M 50/55

(54) **BATTERY CELL ASSEMBLY AND BATTERY UNIT FOR AN ELECTRIC VEHICLE**

(71) Applicant: Volvo Car Corporation, 40531 Göteborg (SE)
(72) Inventor: BERGQVIST, Anders, 40531 Göteborg (SE); FORSSELL, Jonas, 40531 Göteborg (SE)
(74) Representative: Maiwald GmbH

(57) **Abstract**

The disclosure relates to a battery cell assembly (16, 18, 20) for a battery unit (10) of an electric vehicle. The battery cell assembly (16, 18, 20) comprises a plurality of battery cells (22). The battery cells (22) are arranged in two rows (30, 32). All battery cells (22) are electrically connected in series. Moreover, an electromagnetic compensation conductor (42) is provided which is arranged such that the electromagnetic compensation conductor (42) passes by at least a first sub-group of the battery cells (22). Alternatively or additionally, at least one electric inter-row connector (44) electrically connecting one of the poles (28) of one of the battery cells (22) of a first row (30, 32) to one of the poles (28) of one battery cell (22) of a second row (30, 32), is provided and a connection direction of the inter-row connector (44) is inclined with respect to the line-up directions (30a, 32a). Furthermore, a battery unit (10) for an electric vehicle comprising at least one battery cell assembly (16, 18, 20) is presented.

## Description

The present disclosure relates to a battery cell assembly for a battery unit of an electric vehicle.

Moreover, the present disclosure is directed to a battery unit for an electric vehicle, comprising at least one such battery cell assembly.

When using such battery cell assemblies and battery units for propelling the electric vehicle, i.e. if the batteries are traction batteries, comparatively large electric currents need to be provided by the battery cell assembly.

These currents create magnetic fields which are generally not desired in the surroundings of a battery cell assembly. This is especially the case in the passenger compartment or in the vicinity thereof.

Consequently, the problem to be solved by the present disclosure consists in at least decreasing such magnetic fields.

The problem is at least partially solved or alleviated by the subject matter of the independent claims of the present disclosure, wherein further examples are incorporated in the dependent claims.

According to a first aspect, there is provided a battery cell assembly for a battery unit of an electric vehicle. The battery cell assembly comprises a plurality of battery cells. Each battery cell has a battery cell body which is delimited by an end surface on which two poles of the respective battery cell are located. The battery cells are arranged in two rows having parallel line-up directions and all battery cells are oriented such that all end surfaces are oriented to the same side and such that all cell width directions extending between the poles of the respective battery cell are oriented substantially perpendicular to the line-up direction of the corresponding row. Moreover, all battery cells are electrically connected in series. In a first alternative, an electromagnetic compensation conductor is arranged adjacent to the end surfaces such that the electromagnetic compensation conductor passes by at least a first sub-SE:TOP group of the battery cells. In a second alternative, at least one electric inter-row connector electrically connecting one of the poles of one of the battery cells of a first row out of the two rows to one of the poles of one battery cell of a second row out of the two rows is provided. A connection direction of the inter-row connector is inclined with respect to the line-up directions. It is understood that the first alternative and the second alternative do not exclude each other. In other words, the first alternative and the second alternative can be combined.

In the present context, it is understood that an arrangement of the battery cells always refers to a mechanical arrangement thereof. The same applies to an orientation. Moreover, the designation of the sub-group as a "first" sub-group only serves the ease of explanation. No actual number of sub-groups is implied.

The fact that the connection direction is inclined, means that it is neither parallel nor perpendicular to the line-up direction. Such a connection direction can also be designated a diagonal connection even though it is not necessary that it is perfectly diagonal.

In the configuration according to the first alternative, the electric current passes through the electromagnetic compensation conductor and through the battery cells being connected in series. However, at least in some areas, the current in the electromagnetic compensation conductor travels in an opposite direction as compared to the series connection of the battery cells. Consequently, the electromagnetic compensation conductor has a cancellation effect on a magnetic field being created by the series connection of the battery cells. In other words, the magnitude of a magnetic field in the surroundings of the battery cell assembly is decreased by the electromagnetic compensation conductor.

In the second alternative, the inter-row connectors with the inclined connection direction lead to a situation in which the series connection of the battery cells can be realized such conductor loops having comparatively large areas are avoided. The benchmark of assessing the size of such conductor loops is the size of the battery cell assembly. In other words, due to the inter-row connectors with inclined connection directions, the battery cells can be connected in series and only conductor loops having comparatively small areas are created by a current passing through the loop. It is known that the area of a conductor loop has a direct effect on the magnitude of a magnetic field. Consequently, also in this alternative, the magnitude of a magnetic field is reduced. Furthermore, the inclined connection directions offer the possibility to create the small area conductor loops such that the corresponding current directions are opposed. Consequently, from a magnetic perspective, the conductor loops of the series connection cancel each other or at least provide a further decrease of the magnetic field in the surroundings of the battery cell assembly.

It is noted that none of the above mentioned alternatives affects the performance of the battery cell assembly. This means that the magnetic field in the surroundings of the battery cell assembly is decreased without making compromises on the performance.

In an example, the rows of battery cells may have the same length. This is advantageous from a packaging perspective. In other words, such battery cell assemblies can efficiently use a space provided for their installation.

In an example, the electromagnetic compensation conductor may be formed by a so-called bus bar. Such conductors are simple in design and reliable in operation.

The battery cell assembly of the present disclosure may be used for powering one phase of an electric traction machine. For powering a two phase electric traction machine, the battery cell assembly of the present disclosure may be used twice. For powering a three phase electric traction machine, the battery cell assembly of the present disclosure may be used three times, etc.

In an example, the electromagnetic compensation conductor passes by all of the battery cells. This may be the case if the battery cell assembly is viewed in a direction being substantially perpendicular to the end surfaces of the battery cells. In such a configuration the electromagnetic compensation conductor provides a comparatively high compensation or cancellation effect.

In an example, the electromagnetic compensation conductor follows a current path through the centers of the battery cell rows. This path through the center of the battery cell rows may also be called a path of an averaged net current passing through all battery cells. If the electromagnetic compensation conductor follows this path, the current passing through the electromagnetic compensation conductor is mapped on the current flowing through the battery cells. Consequently, a cancellation effect of high performance is created.

In an example, a current direction of the electromagnetic compensation conductor is opposed to a direction of the averaged net current flowing through the battery cells being connected in series. It is noted that the current direction of the electromagnetic compensation conductor can be chosen by the manner how the electromagnetic compensation conductor is connected to the positive pole and the negative pole of the battery cell assembly or of a battery unit comprising the battery cell assembly. The opposed directions also lead to a reliable cancellation effect.

In an example, the battery cell assembly may comprise at least one pair of battery cells being arranged adjacent to one another within the same row. A first electric inter-row connector may be connected to one of the poles of one battery cell forming the pair, and a second electric inter-row connector may be connected to an adjacent one of the poles of the other battery cell forming the pair, the first electric inter-row connector and the second electric inter-row connector crossing each other. The poles mentioned above may be positive or negative. It is understood that the first and second electric inter-row connector cross each other without being electrically connected. This configuration further facilitates the creation of a series connection of the battery cells, wherein only conductor loops of small areas are created which ideally have current directions of opposite signs such that the magnetic fields created by the conductor loops cancel each other or at least partially compensate each other.

In an example, the battery cell assembly comprises at least one second sub-group of adjacent battery cells being arranged in the same row. At least one of the poles of the second sub-group being arranged at an end thereof along the line-up direction, is electrically connected to the inter-row connector. This configuration helps to create conductor loops of small areas when connecting the battery cells in series. As before, the designation of the sub-group as a "second" sub-group serves the ease of explanation only. A number of sub-groups is not implied. Moreover, the second sub-group is generally independent from first sub-group. However, it is possible that the first sub-group and the second sub-group overlap.

In an example, two of the poles of the second sub-group being arranged at opposites ends thereof along the line-up direction, are electrically connected to a respective inter-row connector. This configuration further helps to create conductor loops of small areas when connecting the battery cells in series. Furthermore, following this arrangement, the conductor loops may be arranged such that the resulting magnetic fields have opposite directions.

In an example, the second sub-group comprises an even number of battery cells. The second sub-group for example comprises 2, 4, 6, 8, 10 or 12 battery cells. The creation of small area conductor loops and magnetic fields having opposite directions is, thus, further facilitated.

In an example, the battery cell assembly comprises at least one third sub-group of at least three adjacent battery cells being arranged in the same row. An electric intra-row connector connects two poles of the third sub-group being arranged at respective ends thereof along the line-up direction, while bypassing the remaining battery cells of the third sub-group. Again, the designation of the sub-group as a "third" sub-group serves the ease of explanation. As before, no number of sub-groups is implied. The fact that the intra-row connector is able to bypass or jump one battery cell of the third sub-group makes it possible to create conductor loops of small areas when connecting the battery cells in series. As before, the third sub-group is generally independent from the first sub-group and the second sub-group. However, it is possible that the third sub-group overlaps the first sub-group and/or second sub-group at least partially.

In an example, the intra-row connector is substantially oriented in parallel to the line-up direction. It is understood that the battery cells to be connected with the intra-row connector are oriented such that poles of opposite polarity are connected. Thus, the intra-row connector covers the shortest distance between the poles of the battery cells to be connected therewith. This is efficient from several perspectives. First, the material for the intra-row connector is efficiently used. Second, the intra-row connector occupies a comparatively small space.

In an example, the third sub-group comprises three battery cells. Consequently, conductor loops of small area can be created.

In an example, each battery cell comprises a cell-level control unit. Thus, single battery cells may be controlled on cell-level. Cell-level characteristics and circumstances, e.g. ageing or thermal conditions can be respected. This allows for an efficient control of the battery cells and the battery cell assembly. Such battery cells may be called smart cells.

In an example, the cell-level control unit comprises at least one of a cell-level inverter and a cell-level DC-DC-converter. If a cell level-inverter is used, also alternating currents (AC) are present in the battery cell assembly leading to the creation of magnetic fields.

It is noted that the cell-level control unit may be connected to a single battery cell or to a group of battery cells.

According to a second aspect, there is provided a battery unit for an electric vehicle. The battery unit comprises at least one battery cell assembly according to the present disclosure, wherein a first electric end of the battery cells being connected in series is electrically connected to a first connection terminal of the battery unit and a second electric end of the battery cells being connected in series is electrically connected to a second connection terminal of the battery unit. As has already been explained before, such a battery unit can be used as an energy source for propelling an electric vehicle. Due to the characteristics of the battery cell assembly as explained above, the magnitude of magnetic fields in the surroundings of the battery unit is low.

In an example, the battery unit comprises at least two battery cell assemblies according to the present disclosure. A first electric end of the battery cells of a first battery cell assembly is electrically connected to the first connection terminal of the battery unit and a second electric end of the first battery cell assembly is electrically connected to the second connection terminal of the battery unit. A first electric end of the battery cells of a second battery cell assembly is electrically connected to a third connection terminal of the battery unit and a second electric end of the second battery cell assembly is electrically connected to a fourth connection terminal of the battery unit. Such a battery unit can for example be used for powering a two phase electric machine, wherein one phase of the electric machine is connected to the first and second connection terminals of the battery unit and the second phase of the electric machine is connected to the third and fourth connection terminal of the battery unit.

Of course, it is also possible that the battery unit comprises three battery cell assemblies according to the present disclosure and the three battery cell assemblies are connected to a three phase electric machine.

If the battery cells comprises cell-level control units having a cell-level inverter, electric machines can be connected directly to the connection terminals of the battery unit.

If the battery cells do not comprises a cell-level inverter, the connection terminals of the battery unit may be connected to an inverter unit. Electric machines for propelling the vehicle may also be connected to the inverter unit.

It should be noted that the above examples may be combined with each other irrespective of the aspect involved.

These and other aspects of the present disclosure will become apparent from and elucidated with reference to the examples described hereinafter.

Examples of the disclosure will be described in the following with reference to the following drawings.
- Fig. 1: shows a battery unit according to the present disclosure comprising battery cell assemblies according to a first example,
- Fig. 2: shows a battery unit according to the present disclosure comprising battery cell assemblies according to a second example,
- Fig. 3: shows a battery unit according to the present disclosure comprising battery cell assemblies according to a third example,
- Fig. 4: shows a battery unit according to the present disclosure comprising battery cell assemblies according to a fourth example, and
- Fig. 5: shows an example of a battery cell being used in the battery cell assemblies of Figures 1 to 4.

The figures are merely schematic representations and serve only to illustrate examples of the disclosure. Identical or equivalent elements are in principle provided with the same reference signs.

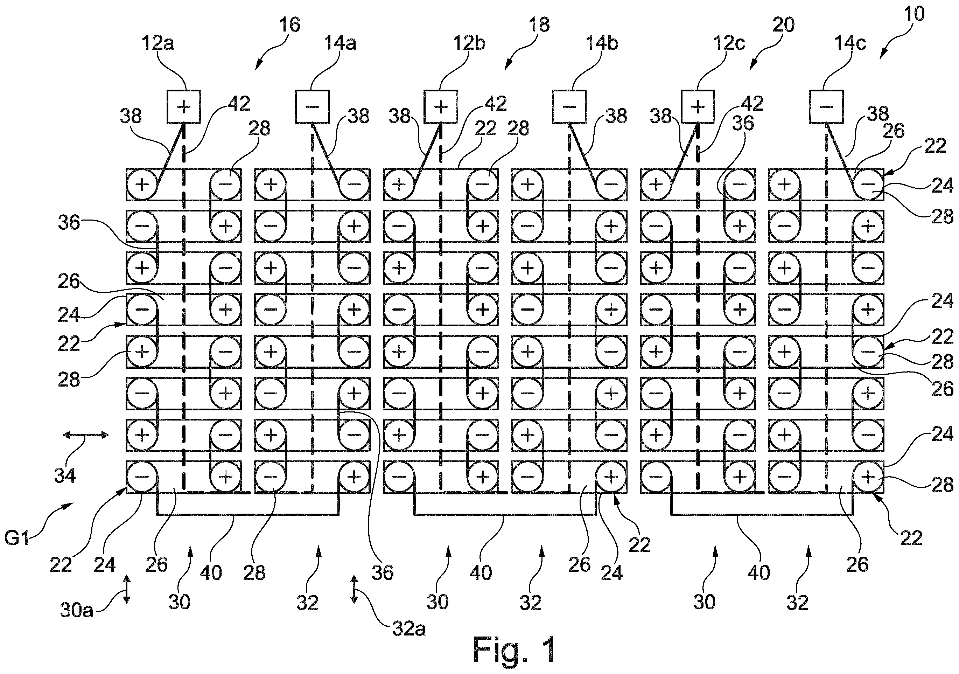

Figure 1 shows a battery unit 10 for an electric vehicle.

The battery unit 10 is configured for powering a three phase electric machine. It comprises a first connection terminals 12a, a second connection terminal 14a, a third connection terminal 12b, a fourth connection terminal 14b, a fifth connection terminal 12c and a sixth connection terminal 14c. In the present example, the first, third and fifth connection terminals 12a, 12b, 12c are positive connection terminals and the second, fourth and sixth connection terminals 14a, 14b, 14c are negative connection terminals.

The connection terminals 12a, 14a are configured for being electrically connected to a first phase of the electric machine.

The connection terminals 12b, 14b are configured for being electrically connected to a second phase of the electric machine.

The connection terminals 12c, 14c are configured for being electrically connected to a third phase of the electric machine.

The battery unit 10 comprises three battery cell assemblies 16, 18, 20.

Each battery cell assembly 16, 18, 20 comprises a plurality of battery cells being generally designated with references sign 22 for all battery cell assemblies.

In the examples shown in the figures, each battery cell assembly 16, 18, 20 comprises a total of 16 battery cells 22, however this is purely illustrative.

Each battery cell has a battery cell body 24 which is delimited by an end surface 26 on which two poles 28, i.e. a positive pole and a negative pole are located. Positive poles are marked with a "+" in the Figures and negative poles are marked with a "-".

It is noted that for better visibility only some of the battery cells 22, the battery cell bodies 24, the end surfaces 26 and the poles 28 are designated with a reference sign.

The battery cells 22 of each battery cell assembly 16, 18, 20 are arranged in two rows 30, 32 having parallel line-up directions 30a, 32a.

Moreover, all battery cells 22 of each battery cell assembly 16, 18, 20 are oriented such that all end surfaces 26 are oriented to the same side and such that all cell width directions 34 extending between the poles 28 of the respective battery cell 22 are oriented substantially perpendicular to the line-up direction 30a, 32a of the corresponding row 30, 32.

Furthermore, all battery cells 22 of one battery cell assembly 16, 18, 20 are electrically connected in series. A first electric end of the battery cells 22 of the battery cell assembly 16 being connected in series is electrically connected to the first connection terminal 12a and a second electric end of these battery cells 22 is electrically connected to the second connection terminal 14a of the battery unit 10. A first electric end of the battery cells 22 of the battery cell assembly 18 being connected in series is electrically connected to the third connection terminal 12b and a second electric end of these battery cells 22 is electrically connected to the fourth connection terminal 14b of the battery unit 10. A first electric end of the battery cells 22 of the battery cell assembly 20 being connected in series is electrically connected to the fifth connection terminal 12c and a second electric end of these battery cells 22 is electrically connected to the sixth connection terminal 14c of the battery unit 10.

To this end, first type connectors 36 are used for electrically connecting the poles 28 of adjacent battery cells 22. For better visibility, only some of the first type connectors 36 are equipped with a references sign in the Figures.

The first type connectors 36 substantially extend parallel to the line-up directions 30a, 32a.

The battery cells 22 being located at a first end of the rows 30, 32 which is located adjacent to the connection terminals 12a, 12b, 12c, 14a, 14b, 14c of the battery unit 10 are electrically connected to the corresponding connection terminals 12a, 12b, 12c, 14a, 14b, 14c by a second type connector 38 respectively.

At a second end of the rows 30, 32 being arranged opposite the connection terminals 12a, 12b, 12c, 14a, 14b, 14c, the poles 28 of adjacent battery cells 22, i.e. the last battery cell 22 in row 30 and the last battery cell 22 in row 32, are connected by a third type connector 40. This connector can also be designated an end of row connector.

Consequently, in the example of Figure 1, the current travels through the rows 30, 32 of each battery cell assembly 16, 18, 20 in a zig-zag pattern.

This current may create an undesired magnetic field.

In order to decrease the magnitude of such a magnetic field or to fully compensate the magnetic field, each battery cell assembly 16, 18, 20 comprises an electromagnetic compensation conductor 42 which is arranged adjacent to the end surfaces 26 such that the electromagnetic compensation conductor 42 passes by all of the battery cells 22 of the respective battery cell assembly.

It is noted that it is also possible that the electromagnetic compensation conductor 42 passes by a first sub-group G1 of battery cells 22 only, i.e. not by all of them. Also in such a situation a compensation effect is provided.

The electromagnetic compensation conductor 42 follows a current path through the centers of the respective battery cell rows 30, 32.

It is noted that the electromagnetic compensation conductor 42 is not connected to any of the poles 28. Moreover, it is noted that the electromagnetic compensation conductor 42 is represented by a dashed line for illustrative purposes only. Of course, the electromagnetic compensation conductor 42 is a continuous part.

The current direction of the electromagnetic compensation conductor 42 is opposed to a direction of the averaged net current passing through the battery cells 22 connected in series.

Thus, the current travelling through the electromagnetic compensation conductor 42 creates a magnetic field which is oriented such that it at least partially compensates the magnetic field resulting from the electric series connection of the battery cells 22.

Each battery assembly 16, 18, 20 is configured for powering one of the phases of the electric machine.

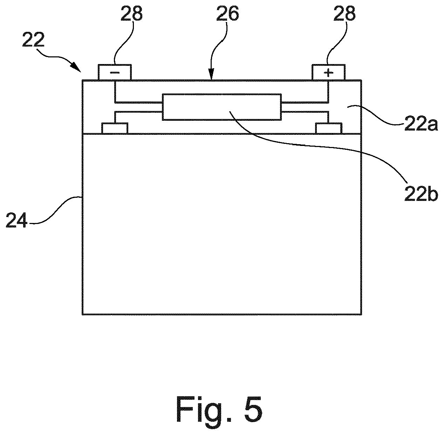

In this context, the battery cells 22 may comprises a cell-level control unit 22a with a cell-level inverter 22b (cf. Figure 5). In such a case, alternating current (AC) can be provided at the connection terminals 12a, 12b, 12c, 14a, 14b, 14c and the electric machine can be directly electrically connected thereto. It is noted that in such a case, the poles 28 being marked with a "+" strictly speaking are not positive poles and the poles 28 being marked with a "-" strictly speaking are not negative poles.

Alternatively, the battery cells 22 do not comprise such a cell-level control unit. In this case, the connection terminals 12a, 12b, 12c, 14a, 14b, 14c may be connected to respective input terminals of an inverter unit and the output terminals of the inverter unit may be connected to the electric machine.

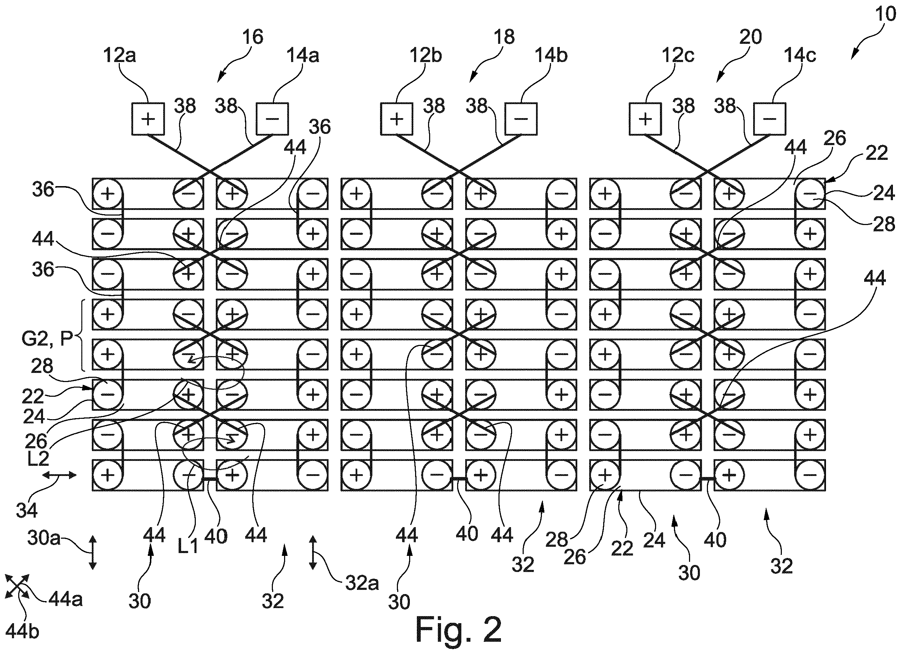

Figure 2 shows a battery unit 10, which comprises three battery cell assemblies 16, 18, 20 according to a second example.

In the following, only the differences with respect to the example of Figure 1 will be explained.

In addition to the above described first type connectors 36, second type connectors 38 and third type connectors 40, the example of Figure 2 uses several electric inter-row connectors 44 which may also be designated fourth type connectors.

For better visibility, only some of the electric inter-row connectors 44 have been equipped with a reference sign.

Each of the electric inter-row connectors 44 electrically connects one poles 28 of one of the battery cells 22 of row 30 to one of the poles 28 of one battery cell 22 of row 32.

A connection direction 44a, 44b of the inter-row connector 44 is inclined with respect to the line-up directions 30a, 32a. This means that the connection direction is neither parallel nor perpendicular to the line-up directions 30a, 32a.

Moreover, in the example of Figure 2, in each row 30, 32 pairs P of battery cells 22 being arranged adjacent to one another can be found.

Within these pairs P, one electric inter-row connector 44 is connected to one of the poles 28 of one battery cell 22 forming the pair P and another electric inter-row connector 44 is connected to an adjacent one of the poles 28 of the other battery cell 22 forming the pair P. These electric inter-row connectors 44 cross each other.

The pairs P of battery cells 22 are connected among each other via first type connectors 36.

It is noted that electric inter-row connectors 44 crossing each other are not electrically connected.

The pairs P of battery cells 22 may in the present example also be designate a second sub-group G2, wherein along the respective line-up direction 30a, 32a, two poles 28 of the second sub-group G2 being arranged at opposites ends thereof along the line-up direction 30a, 32a, are electrically connected to a respective inter-row connector 44.

In the present example, the second sub-group G2 comprises an even number of battery cells 22.

The configuration of the battery cell assemblies 16, 18, 20 according to Figure 2 has the effect that compared to the general size of the battery cell assemblies 16, 18, 20 small current loops are created. Furthermore, these current loops have opposite orientations.

For illustrating this effect, in Figure 2 two exemplary current loops L1 and L2 are represented.

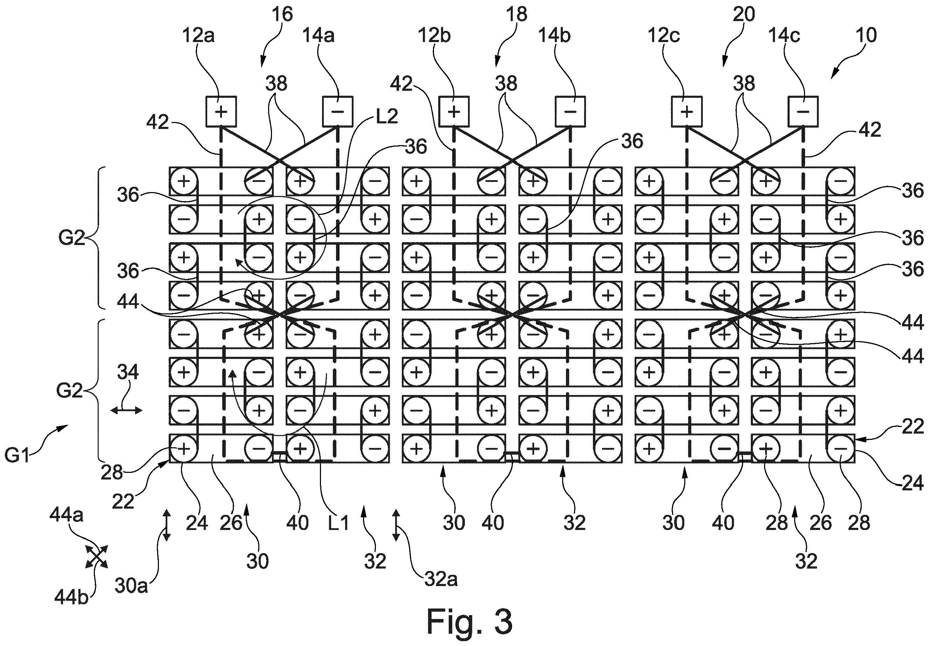

Figure 3 shows a battery unit 10, which comprises three battery cell assemblies 16, 18, 20 according to a third example. The third example is a variant of the second example shown in Figure 2.

In the following, only the differences with respect to the examples of Figures 1 and 2 will be explained.

A first difference over the Example of Figure 2 is that instead of pairs of battery cells 22 of one row 30, 32, second sub-groups G2 of four battery cells 22 are formed and the electric inter-row connectors 44 are connected to poles 28 being arranged at respective ends of the sub-group along the corresponding line-up direction.

A further difference lies in the use of an electromagnetic compensation conductor 42.

In the example of Figure 3, the electromagnetic compensation conductor 42 crosses between the rows at the same position where the electric inter-row connectors 44 are located.

Thus, also in the example of Figure 3, small current loops LI, L2 are created.

Moreover, a potentially remaining electromagnetic field is additionally compensated by the electromagnetic compensation conductor 42.

It is noted that in the same manner as shown in Figure 3, of course, also in the example of Figure 2 an electromagnetic compensation conductor 42 can be arranged.

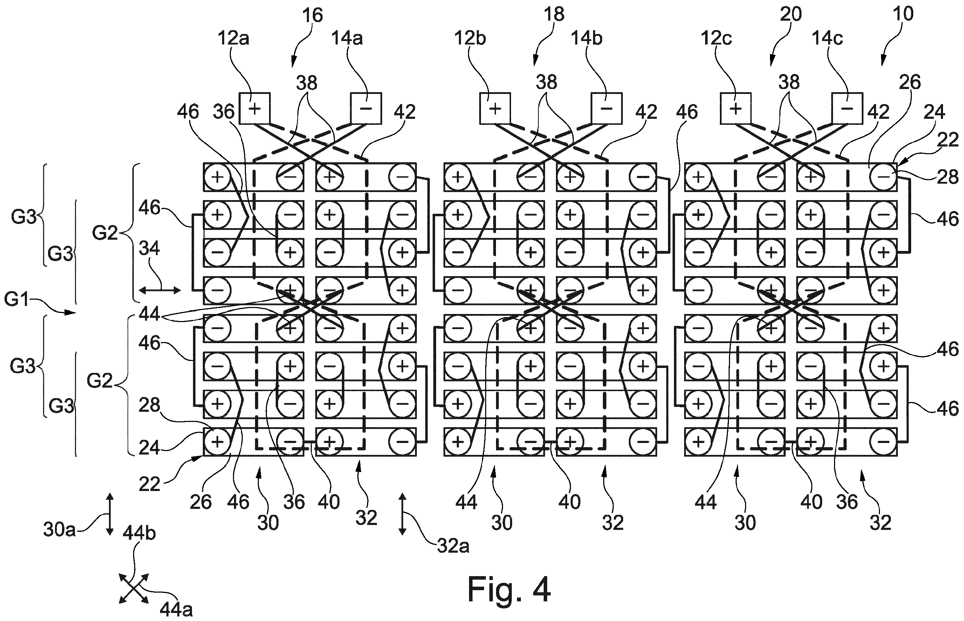

Figure 4 shows a battery unit 10, which comprises three battery cell assemblies 16, 18, 20 according to a fourth example.

In the following, only the differences with respect to the previous examples will be explained. The battery cell assemblies 16, 18, 20 according to the fourth example are derived from the battery cell assemblies 16, 18, 20 according to the third example shown in Figure 3.

Again, second sub-groups G2 of four battery cells 22 of one row 30, 32 are formed.

The connection of these sub-groups via electric inter-row connectors 44 is realized as in the example of Figure 3.

However, in contrast to Figure 3, within this second sub-group G2 of four battery cells 22, two third sub-groups G3 of three battery cells 22 are formed, wherein the battery cells 22 of such a third sub-group G3 are arranged adjacent to one another the same row 30, 32.

With respect to the example of Figure 3, two first type connectors 36 are replaced by respective electric intra-row connectors 46 connecting two poles 28 being arranged at respective ends of the third sub-group G3 along the line-up direction 30a, 32a, while bypassing the remaining battery cell 22 of the third sub-group G3.

In other words, the electric intra-row connectors 46 always jump over one battery cell 22.

The electric intra-row connectors 46 are substantially oriented in parallel to the respective line-up direction 30a, 32a. It is noted that in Figure 4, the electric intra-row connectors 46 are only represented in a flexed condition for illustrating the bypassing. In reality, the electric intra-row connectors 46 are substantially straight.

It is noted that for better visibility, only a few second sub-groups G2, third sub-groups G3 and intra-row connectors 46 are equipped with a reference sign.

Moreover, also in the example of Figure 4 an electromagnetic compensation conductor 42 is used. The electromagnetic compensation conductor 42 corresponds to the one of the example in Figure 3.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### LIST OF REFERENCE SIGNS

- 10: battery unit
- 12a: first connection terminal
- 12b: third connection terminal
- 12c: fifth connection terminal
- 14a: second connection terminal
- 14b: fourth connection terminal
- 14c: sixth connection terminal
- 16: battery cell assembly
- 18: battery cell assembly
- 20: battery cell assembly
- 22: battery cell
- 22a: cell-level control unit
- 22b: cell-level inverter
- 24: battery cell body
- 26: end surface
- 28: pole
- 30: row
- 30a: line-up direction of row 30
- 32: row
- 32a: line-up direction of row 32
- 34: cell width direction
- 36: first type connectors
- 38: second type connector
- 40: third type connector
- 42: electromagnetic compensation conductor
- 44: electric inter-row connector
- 44a: connection direction
- 44b: connection direction
- 46: electric intra-row connector

- P: pair
- G1: first sub-group
- G2: second sub-group
- G3: third sub-group

## Claims

1. A battery cell assembly (16, 18, 20) for a battery unit (10) of an electric vehicle, comprising a plurality of battery cells (22), each battery cell (22) having a battery cell body (24) which is delimited by an end surface (26) on which two poles (28) of the respective battery cell (22) are located,
the battery cells (22) being arranged in two rows (30, 32) having parallel line-up directions (30a, 32a) and all battery cells (22) being oriented such that all end surfaces (26) are oriented to the same side and such that all cell width directions (34) extending between the poles (28) of the respective battery cell (22) are oriented substantially perpendicular to the line-up direction (30a, 32a) of the corresponding row (30, 32), all battery cells (22) being electrically connected in series, and
- an electromagnetic compensation conductor (42) being arranged adjacent to the end surfaces (26) such that the electromagnetic compensation conductor (42) passes by at least a first sub-group (G1) of the battery cells (22), and/or
- at least one electric inter-row connector (44) electrically connecting one of the poles (28) of one of the battery cells (22) of a first row (30, 32) out of the two rows (30, 32) to one of the poles (28) of one battery cell (22) of a second row (30, 32) out of the two rows (30, 32), a connection direction (44a, 44b) of the inter-row connector (44) being inclined with respect to the line-up directions (30a, 32a).

2. The battery cell assembly (16, 18, 20) according to claim 1, wherein the electromagnetic compensation conductor (42) passes by all of the battery cells (22).

3. The battery cell assembly (16, 18, 20) according to claim 1 or claim 2, wherein the electromagnetic compensation conductor (42) follows a current path through the centers of the battery cell rows (30, 32).

4. The battery cell assembly (16, 18, 20) according to claim 3, wherein a current direction of the electromagnetic compensation conductor (42) is opposed to a direction of an averaged net current flowing through the battery cells (22) being connected in series.

5. The battery cell assembly (16, 18, 20) according to any one of the preceding claims, comprising at least one pair (P) of battery cells (22) being arranged adjacent to one another within the same row (30, 32), wherein a first electric inter-row connector (44) is connected to one of the poles (28) of one battery cell (22) forming the pair (P), and a second electric inter-row connector (44) is connected to an adjacent one of the poles (28) of the other battery cell (22) forming the pair (P), the first electric inter-row connector (44) and the second electric inter-row connector (44) crossing each other.

6. The battery cell assembly (16, 18, 20) according to any one of the preceding claims, comprising at least one second sub-group (G2) of adjacent battery cells (22) being arranged in the same row (30, 32), wherein at least one of the poles (28) of the second sub-group (G2) being arranged at an end thereof along the line-up direction (30a, 32a), is electrically connected to the inter-row connector (44).

7. The battery cell assembly (16, 18, 20) according claim 6, wherein two of the poles (28) of the second sub-group (G2) being arranged at opposites ends thereof along the line-up direction (30a, 32a), are electrically connected to a respective inter-row connector (44).

8. The battery cell assembly (16, 18, 20) according to claim 6 or claim 7, wherein the second sub-group (G2) comprises an even number of battery cells (22).

9. The battery cell assembly (16, 18, 20) according to any one of the preceding claims, comprising at least one third sub-group (G3) of at least three adjacent battery cells (22) being arranged in the same row (30, 32), wherein an electric intra-row connector (46) connects two poles (28) of the third sub-group (G3) being arranged at respective ends thereof along the line-up direction (30a, 32a), while bypassing the remaining battery cells (22) of the third sub-group (G3).

10. The battery cell assembly (16, 18, 20) according to claim 9, wherein the intra-row connector (46) is substantially oriented in parallel to the line-up direction (30a, 32a).

11. The battery cell assembly (16, 18, 20) according to claim 9 or claim 10, **characterized in that** the third sub-group (G3) comprises three battery cells (22).

12. The battery cell assembly (16, 18, 20) according to any one of the preceding claims, wherein each battery cell (22) comprises a cell-level control unit (22a).

13. The battery cell assembly (16, 18, 20) according to claim 12, wherein the cell-level control unit (22a) comprises at least one of a cell-level inverter (22b) and a cell-level DC-DC-converter.

14. A battery unit (10) for an electric vehicle, comprising at least one battery cell assembly (16, 18, 20) according to the preceding claims, wherein a first electric end of the battery cells (22) being connected in series is electrically connected to a first connection terminal (12a) of the battery unit (10) and a second electric end of the battery cells (22) being connected in series is electrically connected to a second connection terminal (14a) of the battery unit (10).

15. The battery unit (10) of claim 14, comprising at least two battery cell assemblies (16, 18, 20) according to claims 1 to 13, wherein a first electric end of the battery cells (22) of a first battery cell assembly (16, 18, 20) is electrically connected to the first connection terminal (12a) of the battery unit (10) and a second electric end of the first battery cell assembly (16, 18, 20) is electrically connected to the second connection terminal (14a) of the battery unit (10), and
a first electric end of the battery cells (22) of a second battery cell assembly (16, 18, 20) is electrically connected to a third connection terminal (12b) of the battery unit (10) and a second electric end of the second battery cell assembly (16, 18, 20) is electrically connected to a fourth connection terminal (14b) of the battery unit (10).

## Amended claims

### Amended claims in accordance with Rule 137(2) EPC.

1. A battery cell assembly (16, 18, 20) for a battery unit (10) of an electric vehicle, comprising a plurality of battery cells (22), each battery cell (22) having a battery cell body (24) which is delimited by an end surface (26) on which two poles (28) of the respective battery cell (22) are located,
the battery cells (22) being arranged in two rows (30, 32) having parallel line-up directions (30a, 32a) and all battery cells (22) being oriented such that all end surfaces (26) are oriented to the same side and such that all cell width directions (34) extending between the poles (28) of the respective battery cell (22) are oriented perpendicular to the line-up direction (30a, 32a) of the corresponding row (30, 32), all battery cells (22) being electrically connected in series, **characterized by**
- an electromagnetic compensation conductor (42) being arranged adjacent to the end surfaces (26) such that the electromagnetic compensation conductor (42) passes by at least a first sub-group (G1) of the battery cells (22), and/or
- at least one electric inter-row connector (44) electrically connecting one of the poles (28) of one of the battery cells (22) of a first row (30, 32) out of the two rows (30, 32) to one of the poles (28) of one battery cell (22) of a second row (30, 32) out of the two rows (30, 32), a connection direction (44a, 44b) of the inter-row connector (44) being inclined with respect to the line-up directions (30a, 32a).

2. The battery cell assembly (16, 18, 20) according to claim 1, wherein the electromagnetic compensation conductor (42) passes by all of the battery cells (22).

3. The battery cell assembly (16, 18, 20) according to claim 1 or claim 2, wherein the electromagnetic compensation conductor (42) follows a current path through the centers of the battery cell rows (30, 32).

4. The battery cell assembly (16, 18, 20) according to claim 3, wherein a current direction of the electromagnetic compensation conductor (42) is opposed to a direction of an averaged net current flowing through the battery cells (22) being connected in series.

5. The battery cell assembly (16, 18, 20) according to any one of the preceding claims, comprising at least one pair (P) of battery cells (22) being arranged adjacent to one another within the same row (30, 32), wherein a first electric inter-row connector (44) is connected to one of the poles (28) of one battery cell (22) forming the pair (P), and a second electric inter-row connector (44) is connected to an adjacent one of the poles (28) of the other battery cell (22) forming the pair (P), the first electric inter-row connector (44) and the second electric inter-row connector (44) crossing each other.

6. The battery cell assembly (16, 18, 20) according to any one of the preceding claims, comprising at least one second sub-group (G2) of adjacent battery cells (22) being arranged in the same row (30, 32), wherein at least one of the poles (28) of the second sub-group (G2) being arranged at an end thereof along the line-up direction (30a, 32a), is electrically connected to the inter-row connector (44).

7. The battery cell assembly (16, 18, 20) according claim 6, wherein two of the poles (28) of the second sub-group (G2) being arranged at opposites ends thereof along the line-up direction (30a, 32a), are electrically connected to a respective inter-row connector (44).

8. The battery cell assembly (16, 18, 20) according to claim 6 or claim 7, wherein the second sub-group (G2) comprises an even number of battery cells (22).

9. The battery cell assembly (16, 18, 20) according to any one of the preceding claims, comprising at least one third sub-group (G3) of at least three adjacent battery cells (22) being arranged in the same row (30, 32), wherein an electric intra-row connector (46) connects two poles (28) of the third sub-group (G3) being arranged at respective ends thereof along the line-up direction (30a, 32a), while bypassing the remaining battery cells (22) of the third sub-group (G3).

10. The battery cell assembly (16, 18, 20) according to claim 9, wherein the intra-row connector (46) is oriented in parallel to the line-up direction (30a, 32a).

11. The battery cell assembly (16, 18, 20) according to any one of the preceding claims, wherein each battery cell (22) comprises a cell-level control unit (22a).

12. The battery cell assembly (16, 18, 20) according to claim 11, wherein the cell-level control unit (22a) comprises at least one of a cell-level inverter (22b) and a cell-level DC-DC-converter.

13. A battery unit (10) for an electric vehicle, comprising at least one battery cell assembly (16, 18, 20) according to the preceding claims, wherein a first electric end of the battery cells (22) being connected in series is electrically connected to a first connection terminal (12a) of the battery unit (10) and a second electric end of the battery cells (22) being connected in series is electrically connected to a second connection terminal (14a) of the battery unit (10).

14. The battery unit (10) of claim 13, comprising at least two battery cell assemblies (16, 18, 20) according to claims 1 to 12, wherein a first electric end of the battery cells (22) of a first battery cell assembly (16, 18, 20) is electrically connected to the first connection terminal (12a) of the battery unit (10) and a second electric end of the first battery cell assembly (16, 18, 20) is electrically connected to the second connection terminal (14a) of the battery unit (10), and
a first electric end of the battery cells (22) of a second battery cell assembly (16, 18, 20) is electrically connected to a third connection terminal (12b) of the battery unit (10) and a second electric end of the second battery cell assembly (16, 18, 20) is electrically connected to a fourth connection terminal (14b) of the battery unit (10).
